# EUROPEAN PATENT SPECIFICATION

(11) **EP 4 470 355 B1**
(45) Date of publication and mention of the grant of the patent: **03.09.2025**
(21) Application number: 23701773.6
(22) Date of filing: 26.01.2023
(51) Int. Cl.: H10N 60/355, H01F 6/00

(54) **PERSISTENT CURRENT SWITCH FOR A SUPERCONDUCTING ELECTROMAGNET**
DAUERSTROMSCHALTER FÜR EINEN SUPRALEITENDEN ELEKTROMAGNETEN
COMMUTATEUR DE COURANT PERSISTANT POUR UN ÉLECTROAIMANT SUPRACONDUCTEUR

(30) Priority: 27.01.2022 EP 22020026
(43) Date of publication of application: 04.12.2024
(73) Proprietor: Koninklijke Philips N.V., 5656 AG Eindhoven (NL)
(72) Inventor: HAM, Cornelis, Leonardus, Gerardus, 5656 AG Eindhoven (NL)
(74) Representative: Philips Intellectual Property & Standards
(86) International application number: PCT/EP2023/051885
(87) International publication number: WO 2023/144247

(56) References cited:
- WO-A1-2021/131178
- YANAGISAWA Y ET AL: "Development of a persistent-mode NMR magnet with superconducting joints between high-temperature superconductors", SUPERCONDUCTOR SCIENCE AND TECHNOLOGY, vol. 34, 115006, 17 September 2021 (2021-09-17), XP020370120, DOI: 10.1088/1361-6668/AC2120

## Description

### FIELD OF THE INVENTION

The invention pertains to a persistent current switch for a superconducting magnet, subsequently also called a magnet persistent current switch (MPCS). The superconducting magnet is formed as an electromagnet with magnet windings of superconductive material. When electrical current is introduced into the magnet windings and the magnet windings are cooled below the critical temperature for superconductivity of the material of the magnet windings, the electrical current persistently flows through the windings and a persistent magnet field is generated.

Persistent mode operation of superconducting magnets is explained by M. Wilson in section 11.2 of his book 'Superconducting Magnets' (Oxford University Press, 1983, ISBN 0-19-854805-2).

Persistent mode operation of superconducting magnets is achieved by connecting a superconducting switch in series with the superconducting field-generating coils. This switch comprises an electrical switch in the form of a switchable electrical connector and of a length of superconducting wire wound on a support structure in such a way that it does not contribute to the field of the magnet. In persistent operation, it carries the full magnet electrical current. Heating the switch to a temperature above the superconducting transition temperature causes the switch to become resistive. A power supply connected in parallel to the switch can then be used to change the electrical current in the field generating coils.

### BACKGROUND OF THE INVENTION

Such a magnet persistent current switch is known from the international application WO2019/096567**.**

The magnet persistent current switch that is known from the international application WO2015/096567 has a length of superconducting wire that is part of the magnet windings. That is, part of the windings of the superconducting field-generating coils is circuited to operate as the length of superconducting wire of the magnet persistent current switch.

From the European patent application EP 40 24 415 a magnet persistent current switch is known that is made of a high-temperature superconductor.

WO2021/131178 discloses a persistent current switch according to the preamble of independent claim 1, in particular comprising a superconducting wire having (series-connected) segments of a low-temperature or high-temperature superconducting material, e.g., MgB₂, with respective heaters.

### SUMMARY OF THE INVENTION

An object of the invention is to provide a persistent current switch that enables to reduce the time required for ramping-up the superconducting magnet.

This object is achieved by a persistent current switch for a superconducting magnet according to claim 1, comprising:
a length of superconducting wire having electrical connection ports at the ends of the length of superconducting wire; and
a heater to supply heat to at least a portion of the length of superconducting wire,
wherein the length of superconducting wire includes an lts-segment of low-temperature superconducting material and an hts-segment of high-temperature superconducting material.

An insight of the invention is that the heat dissipation in the magnet persistent current switch (MPCS) during ramp-up or ramp-down, i.e. when electrical current flows through the length of wire, is inversely proportional to the electrical (Ohmic) resistance of the material of the length of wire. The hts-segment of the length of wire is formed with a high-temperature superconductor material that has a very high electrical resistance in its normal state. Hence, for temperatures above the critical temperature for superconductivity of the hts-segment, the hts-segment and hence the length of wire as a whole has a very low heat dissipation during ramping of the magnet. Because only a very low amount of heat dissipated by the magnet persistent current switch needs to be carried-off from the superconducting magnet, the heat dissipation of the magnet persistent current switch is rapidly carried-off and a high ramp speed is enabled. This high ramp speed is mainly enabled by the higher ramp voltage that is allowed, almost without (heat) penalty for dissipation into the magnet's cryogen system. Conventionally, a ramp voltage of 5 V is used in most of the cases. The invention enables to increase the ramp voltage to e.g. 20 V, or even higher. Because the resistivity of the high-temperature superconducting ceramic material is one or several orders of magnitude higher than the resistivity of the low-temperature superconducting material of the lts-segment, the length of the hts-segment may be one or several order of magnitude less than the length of the wire of a conventional MPCS. In practice the lts-segment is made up from a metallic (Cu) matrix or cladding that holds the low-temperature superconducting material, the resistance of the lts-segment may be dominated by the resistivity of the metallic matrix or cladding.

Summarising in general, the MPCS of the invention is used in superconducting magnets to energize them and switch to persistent mode and vice versa to discharge those magnets. In state of the art superconducting magnets, like MRI magnets, the magnet coils are made of standard superconducting wire (also called LTS - Low Temperature Superconductor), such as NbTi and the MPCS is made of that same material. The switch is opened (=becoming normal) by heating the wire to a temperature above the critical temperature of the wire. During the energization of the magnet the same voltage that is used to energize the magnet (=inductance voltage over the magnet coil) is also applied to the MPCS in 'open' state. This leads to dissipation (*V²*/*R*)*.* This dissipation leads to helium boil-off and/or temperature increase for so-called sealed magnets (magnets that are not immerged into a bath of liquid helium). Further, the invention achieves to reduce the heat load to the low-temperature (4 K) structure of the magnet. When applied to a magnet of which the windings are cooled by immerging them in liquid helium, this reduces the amount of helium loss.

According to the invention the MPCS includes a length of wire of at least two different materials in series: a part (lts-segment) is made of LTS wire and another part (hts-segment) is made of HTS wire. The HTS is a ceramic material and its resistance is very high in normal state. So when the MPCS is warmed up above the critical temperature of both LTS and HTS wire, the resistance of the MPCS becomes very high and the dissipation during energize (or discharge) becomes very low.

The hts-segment and the lts-segment may be shaped as straight or twisted lengths of wire or may be wound e.g. as solenoid.

The MPCS of the invention achieves in general:
Reduced dissipation in the magnet due to the MPCS during energize or discharge (except the heater). Less heat load, which means that the magnet warms up less during energize (or discharge). Therefore less time needed for cooling down.

Ability to use high speed ramp up and/or high speed ramp down using a magnet power supply with higher ramp voltage. Instead of a dedicated magnet power supply, the gradient amplifier can be used. As a consequence this reduces the energize and discharge times for ramping-up/down. This is important for 3T sealed magnets, i.e. to energize/discharge within the temperature window (*T*_{AutoDischarge}-*T*_{StartEnergize}) and the ability to finish Auto Discharge before quench, or having a reasonable T_{AutoDischarge}. Higher *T*_{StartEnergize} possible when using a high speed energize.

Fast (controlled) ramp down possible instead of using the quench button (while using high ramp down voltage): 1.5T magnet ramped down in e.g. 5 minutes.

These and other aspects of the invention will be further elaborated with reference to the embodiments defined in the dependent claims.

In an example of the MPCS of the invention the hts-segment is made of a ceramic material (e.g. MgB₂ or YBaCuO, or other HTS cuprate) preferably without a metallic electrically conductive matrix or cladding, so that the hts-segment as a whole has a high ohmic resistance in its normal state above its critical temperature for superconductivity. Yttrium barium copper oxide (YBCO) is a family of crystalline chemical compounds that display high-temperature superconductivity; it includes the first material ever discovered to become superconducting above the boiling point of liquid nitrogen (77 K) at about 93 K. Many YBCO compounds have the general formula YBa₂Cu₃O₇₋ₓ), although materials with other Y:Ba:Cu ratios exist, such as YBa₂Cu₄O_{y} (Y124) or Y₂Ba₄Cu7O_{y} ()_{.} It is part of the more general group of rare-earth barium copper oxides (ReBCO) in which, instead of yttrium, other rare earths are present. These materials are suitable for the hts-segment. Also MgB₂ having a critical temperature of about 39 K may be employed for the hts-segment.

In an example the MPCS of the invention is implemented as a series arrangement of two lts-segments and the hts-segment in between the lts-segments.

Drift and voltage noise of the magnet power source may cause variations of the current in running through both lts-segment and the hts-segment, since these are connected in series. Especially when the hts-segment is cooled to recover to its superconductive state in the final stage of the ramping of the superconducting magnet in the transition state around the critical temperate of the hts-segment varying micropaths may occur that become superconducting and local dissipation due to the mentioned current variations may counteract the superconducting state. During the transition of the hts-segment from its normal to its superconductive state, the lts-segment remains in its normal (resistive) conductive state. The resistance of the lts-segment lowers the voltage noise over the hts-segment of the MPCS, and therefore reduces the dissipation in the micropath inside the hts-segment. In practice, the ohmic resistance of the lts-segment may be dominated by the resistivity of an electrical conducing (e.g. Cu) matrix (cladding or matrix) in which the low-temperature superconducting material (e.g. NbTi) is disposed. The hts-segment preferably does not contain any electrical conductive material as a cladding or a matrix. During cooling at the final stage of the ramping-up process, i.e. when cooling down the MPCS, there is a moment that the hts-segment may be partly superconducting and partly in its normal state. The ceramic superconductor material is made up of a large number of grains or crystalline domains that may have a slightly different ratio of its compounding elements or may have a slightly different crystal structure or may be at slightly different temperatures and different (stray) magnetic fields and hence the effective superconducting critical temperature may have a distribution of varying values over the hts-segment. During recovery of the superconducting state, in the almost final stage only a few of the grains or domains are still in the normal resistive state, i.e. an 'almost superconducting path' may exist, where a chain of grains are superconducting and one or a few grains are still in the normal state. The presence of the lts-segment in series that is still resistive counteracts that the entire voltage noise were over these one or a few grains. In that situation, however, the major dissipation of heat will be accommodated by the lts-segment that is in series with the hts-segment, so that also the final grains or domains will efficiently be cooled to below their individual value of the critical temperature for superconductivity. The voltage applied by the magnet power supply over the length of wire of the MPCS is divided such that the larger contribution is over the lts-segment and only at most a minor portion of the voltage is divided over the hts-segment. Hence, there is only at most low heat dissipation over the hts-segment. Accordingly near the superconducting critical temperature of the hts-material the hts-segment can be efficiently cooled by the cryogen system and robustly recovers its superconducting state while the lts-segment is still in its normal resistive state. Some form of electrically conductive metallic material or metal-oxide may be applied as a matrix, substrate or cladding to increase the uniformity of the dissipation over the hts-segment during cooling, since the electrical current will be diverted to the metal or metal-oxide away from the ceramic high-temperature superconducting material portions that are still in their normal conducting state. As this metal or metal-oxide of the hts-segment has a resistance far less than the electrical resistance of the lts-segment, the power dissipation over the hts-segment remains low and accordingly due to higher ramping voltages the time required for ramping may be shortened. The hts-segment has a much higher resistance in normal state than the resistance of the lts-segment(s). So with addition of the matrix/substrate/cladding this resistance should still be much higher than that of the lts-segment(s), but can be a compromise to make the transition to the normal state easier.

In another example of the MPCS of the invention a capacitance is circuited in parallel to the connection ports so that when during ramping an electrical voltage source (often referred to as the magnet power source) the capacitance is circuited in parallel the magnet power source. This functions as a low-pass filter, viz. as a short-cut to high-frequency noise that may occur during ramping. The capacitor short-cuts the high-frequency noise caused by the variations in the conductivity of the hts-segment. The low-pass filter avoids current fluctuations through the MPCS that may be caused by EM field fluctuations that are due to variations cause by external noise sources such as of the mains power supply, passing vehicles etc. for which the magnet windings are sensitive and may pass on voltage noise to the MPCS.

In a further example of the MPCS of the invention a shunt conductor is circuited in series with a controllable switch circuited in parallel to the hts-segment and optionally also over the lts-segment. The controllable switch is set in its open state while the hts-segment is in its normal state and has a high ohmic resistance, i.e. during ramp-up/down and a voltage is applied by the magnet power source. The controllable switch is closed while the superconducting magnet is in persistent mode during cooling. The shunt conductor protects the hts-segment in the event of a quench of the superconductivity of the hts-segment as current will then pass through the shunt and the resistive lts-segment where the energy form the hts-segment is dissipated.

In yet another example of the MPCS of the invention including a thermal switch is provided between the hts-segment and a thermal connection port. The thermal connection port establishes an entry point to a thermal path to the low-temperature (e.g. 4 K) structure of the magnet that is cooled by the magnet's cryogen system. When implemented in a superconducting magnet, the hts-segment is thermally coupled over thermal switch to a thermal buffer of the superconducting magnet's cryogen system. During cooling of the hts-segment, the thermal switch is closed so that heat is more effective carried-off from the hts-segment to the thermal buffer which decreases time required to cool the hts-segment to become superconducting. When in persistent mode the thermal switch is opened so that the hts lead is thermally insulated.

In another example the lts-segment includes several lts-subsegments and the hts-segment includes one or several hts-subsegments and the lts-subsegments and the one of several hts-subsegments are alternatingly circuited in series. Thus, the hts-subsegment(s) are circuited in series between lts-subsegments. In particular the lts-subsegments may be wound as solenoids that are in series connect by a relatively short piece of wire forming the hts-segment.

The invention also pertains to a superconducting magnet comprising an assembly of superconductive magnet windings and an MPCS with the length of superconducting wire including the lts-segment of low-temperature superconducting material and the hts-segment of high-temperature superconducting material. The superconducting magnet of the invention enables to ramp at a high-voltage so that there is shorter time needed to ramp-up/down.

In an example of the superconducting magnet of the invention a cryogen system is coupled to the assembly of magnet windings, and the magnet persistent current switch has thermal connection port is thermally coupled over the thermal switch to the thermal buffer of the cryogen system. When the thermal switch is closed the thermal connection port is in thermal correspondence with the hts-segment of the MPCS. This provides a thermal path to carry-off heat from the hts-segment to the thermal buffer, while thermally insulating the hts-segment during persistent mode operation.

Further, the invention pertains to a method to ramp-up/down the superconducting magnet of the invention. The thermal switch is closed during cool-down van de MPCS, notably towards the end of the ramp-up process. The thermal switch may also be closed at the end of the ramp-down process to carry-off in a controlled manner heat generated during ramp-down. In one implementation the method for ramping/up down involves the control of the controllable switch in the shunt conductor. In another implementation the method of the invention involves control of the thermal switch between hts-segment and the thermal connection port that is thermally linked to the thermal buffer in the cryogen system of the superconducting magnet. The control of the controllable switch as well as the thermal switch may be implemented independently or in combination.

With this invention the capability to use a gradient amplifier that may be incorporated in the magnet when employed for a magnetic resonance examination system, as magnet power supply can be fully used to ramp the magnet, as well as the use of the gradient coil to ramp down the magnet. Both have the capability of high ramp speed. A dedicated MPCS that provides high voltage is of course also possible.

These and other aspects of the invention will be elucidated with reference to the embodiments described hereinafter and with reference to the accompanying drawings.

### BRIEF DESCRIPTION OF THE DRAWINGS

Figs. 1 and 2 show a diagrammatic representation of the MPCS incorporating the invention with the lts-segment of a certain length of LTS wire and a the hts segment as a piece of HTS, with heater at hts-segment or also heaters for the lts-segment;
Figs. 3 and 4 show a diagrammatic representation of the MPCS incorporating the invention with an electrical switch in parallel, closed during cooling down (recovery to superconducting state) of the hts-segment; Fig. 3 with the electrical switch over hts-segment only, Fig. 4 with switch over hts-segment and (part of) lts-segment; and
Fig. 5 shows a diagrammatic representation of the MPCS incorporating the invention with a thermal switch to a thermal buffer to quickly cool down the MPCS, especially the hts-segment.

### DETAILED DESCRIPTION OF EMBODIMENTS

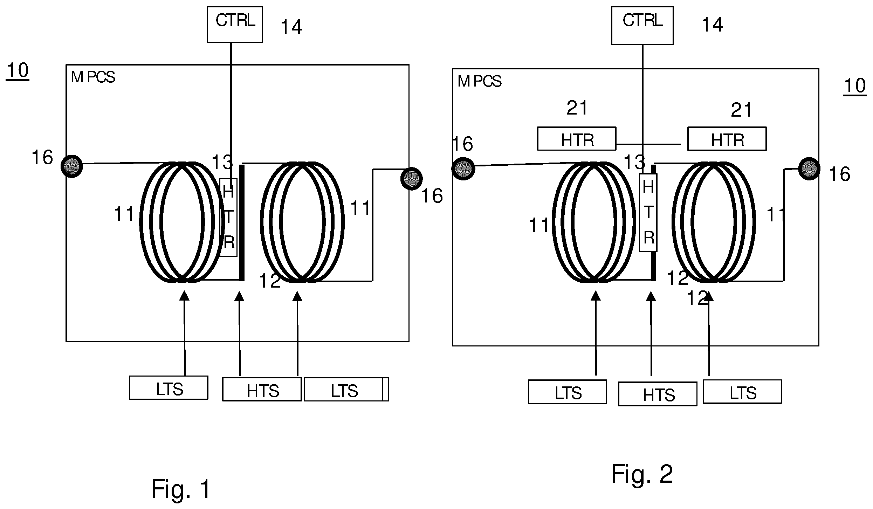

Figs. 1 and 2 show a diagrammatic representation of the MPCS incorporating the invention with the lts-segment of a certain length of LTS wire and the hts-segment as a piece of HTS. with the heater at the hts-segment or also (a) heater(s) for the lts-segment. In the examples of Figs. 1, 2 the lts-segment 11 is formed from two lts-subsegments and the hts-segment 12 is circuited in series between the lts-segments 11. Electrical connection ports 16 are provided to which the magnet windings (not shown) and the magnet power source for injecting current into the magnet windings may be switchable connected. The heater 13 is placed close to the hts-segment such that when in operation it spreads heat to the hts-segment as well as to the lts-segments. The heater 13 is controlled by a control unit 14. The control unit activates the heater when the magnet is ramped so as that the hts-segment 12 and/or the lts-subsegments 11 are in their normal resistive states. The control unit 14 switches off the heater when the lts-subsegments 11 and the hts-segment 12 are to recover to superconductivity as they are cooled by the cryogen system of the magnet when the heater(s) 13, 21 are switched off. In the example of Fig. 2, additional heaters 21 are provided near the lts-subsegments 21 to more efficiently distribute heat over the length of superconducting wire 11, 12.

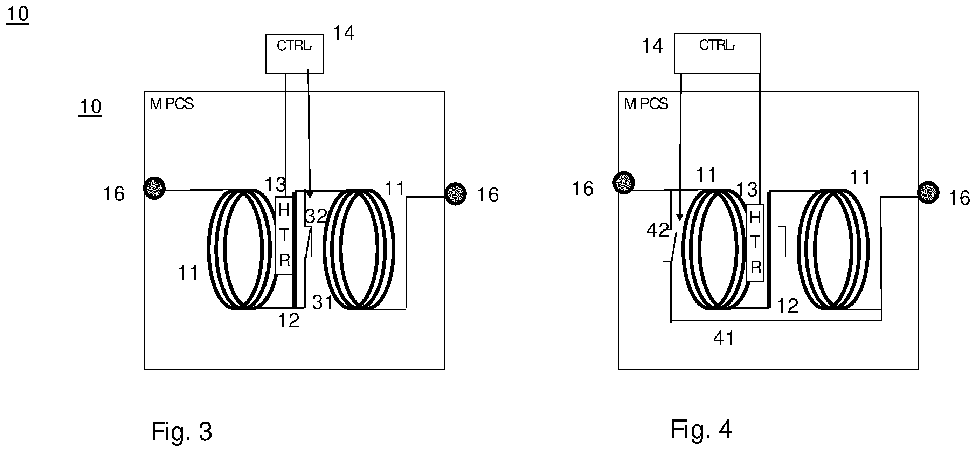

Figs. 3 and 4 show a diagrammatic representation of the MPCS incorporating the invention with an electrical switch in parallel, closed during cooling down (recovery to superconducting state) of the hts-segment; Fig. 3 with switch over hts-segment only, Fig. 4 with switch over hts-segment and (part of) lts-segment. In the example of Fig. 3 the shunt conductor with its switch is arranged in parallel with the hts-segment 12. In the example of Fig. 4 the shunt conductor 41 with its switch 42 is circuited in parallel over both the lts-subsegments and the hts-segment.

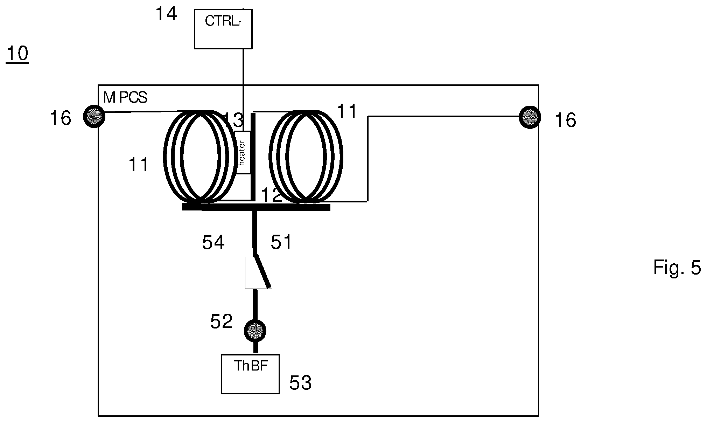

Fig. 5 shows a diagrammatic representation of the MPCS incorporating the invention with a thermal switch to a thermal buffer to quickly cool down the MPCS, especially the hts-segment. The length of superconducting wire 11, 12 of the MPCS 10 is thermally coupled to a thermal conductor 54 made of thermally well conducting material. The thermal conductor is in thermal contact with one end of the thermal switch 51 that has its other end in thermal contact 52 with the thermal buffer 53. The thermal switch may be activated by the control unit 14.

## Claims

1. A persistent current switch (10) for a superconducting magnet, comprising:
a length of superconducting wire having electrical connection ports (16) at its ends;
and
a heater (13, 21) to supply heat to at least a portion of the length of superconducting wire,
**characterised in that** the
length of superconducting wire includes an LTS-segment (11) of low-temperature superconducting material and an HTS-segment (12) of high-temperature superconducting material.

2. The persistent current switch of claim 1, wherein the HTS-segment is formed from a ceramic high-temperature superconducting material.

3. The persistent current switch of claim 1 or 2, wherein a capacitance is circuited in parallel to the electrical connection ports.

4. The persistent current switch according to any of the preceding claims, wherein a shunt conductor (31, 41) in series with a controllable switch (32,42) is circuited in parallel to the LTS-segment and/or the HTS-segment.

5. The persistent current switch according to any of the preceding claims, including a thermal switch (51) between the HTS-segment and a thermal connection port (52).

6. The persistent current switch according to any of the preceding claims, in which the LTS-segment includes several LTS-subsegments and the HTS-segment includes one or several HTS-subsegments and the LTS-subsegments and the one of several HTS-subsegments are alternatingly circuited in series.

7. A superconducting magnet comprising an assembly of magnet windings and a persistent current switch according to any of the claims 1 to 6.

8. The superconducting magnet according to claim 7 when depending on claim 5, comprising a cryogen system coupled to the assembly of magnet windings, wherein the thermal connection port is thermally coupled to a thermal buffer (53) of the cryogen system

9. A method of ramping a superconducting magnet according to claim 7 when depending on claim 4, comprising controlling the controllable switch of the shunt conductor (31,41) in its open state while the HTS-segment is in its normal conductive state.

10. A method of ramping a superconducting magnet of claim 8, comprising controlling the thermal switch in its closed state during ramp-up.

## Patentansprüche

1. Dauerstromschalter (10) für einen supraleitenden Magneten, umfassend:
eine Länge supraleitenden Drahtes, der elektrische Verbindungsanschlüsse (16) an seinen Enden aufweist; und
eine Heizeinrichtung (13, 21), um mindestens einen Teil der Länge supraleitenden Drahtes mit Wärme zu versorgen,
**dadurch gekennzeichnet, dass** die Länge supraleitenden Drahtes ein LTS-Segment (11) aus Niedertemperatur-Supraleitermaterial und ein HTS-Segment (12) aus Hochtemperatur-Supraleitermaterial beinhaltet.

2. Dauerstromschalter nach Anspruch 1, wobei das HTS-Segment aus einem keramischen Hochtemperatur-Supraleitermaterial gebildet ist.

3. Dauerstromschalter nach Anspruch 1 oder 2, wobei eine Kapazität parallel zu den elektrischen Verbindungsanschlüssen geschaltet ist.

4. Dauerstromschalter nach einem der vorstehenden Ansprüche, wobei ein Nebenschlussleiter (31, 41) in Reihe mit einem steuerbaren Schalter (32, 42) parallel zu dem LTS-Segment und/oder dem HTS-Segment geschaltet ist.

5. Dauerstromschalter nach einem der vorstehenden Ansprüche, der einen Thermoschalter (51) zwischen dem HTS-Segment und einem Thermoverbindungsanschluss (52) beinhaltet.

6. Dauerstromschalter nach einem der vorstehenden Ansprüche, wobei das LTS-Segment mehrere LTS-Teilsegmente und das HTS-Segment ein oder mehrere HTS-Teilsegmente beinhaltet, und die LTS-Teilsegmente und das eine von mehreren HTS-Teilsegmenten abwechselnd in Reihe geschaltet sind.

7. Supraleitender Magnet, der eine Anordnung von Magnetwicklungen und einen Dauerstromschalter nach einem der Ansprüche 1 bis 6 umfasst.

8. Supraleitender Magnet nach Anspruch 7, sofern abhängig von Anspruch 5,
der ein an die Anordnung von Magnetwicklungen gekoppeltes Kryogensystem umfasst, wobei der thermische Verbindungsanschluss thermisch an einen thermischen Puffer (53) des Kryogensystems gekoppelt ist.

9. Verfahren zum Hochfahren eines supraleitenden Magneten nach Anspruch 7, sofern abhängig von Anspruch 4, das Steuern des steuerbaren Schalters des Nebenschlussleiters (31, 41) in seinen offenen Zustand umfasst, während sich das HTS-Segment in seinem normalen leitfähigen Zustand befindet.

10. Verfahren zum Hochfahren eines supraleitenden Magneten nach Anspruch 8, das Steuern des Thermoschalters in seinen geschlossenen Zustand während des Hochfahrens umfasst.

## Revendications

1. Commutateur de courant persistant (10) pour un aimant supraconducteur, comprenant :
une longueur de fil supraconducteur présentant des ports de raccordement électrique (16) à ses extrémités ; et
un élément chauffant (13, 21) pour fournir de la chaleur à au moins une partie de la longueur du fil supraconducteur,
**caractérisé en ce que** la longueur de fil supraconducteur inclut un segment LTS (11) de matériau supraconducteur à basse température et un segment HTS (12) de matériau supraconducteur à haute température.

2. Commutateur de courant persistant selon la revendication 1, dans lequel le segment HTS est formé à partir d'un matériau supraconducteur à haute température en céramique.

3. Commutateur de courant persistant selon la revendication 1 ou 2, dans lequel une capacitance est montée en parallèle des ports de raccordement électrique.

4. Commutateur de courant persistant selon l'une quelconque des revendications précédentes, dans lequel un conducteur shunt (31, 41) en série avec un commutateur commandable (32, 42) est monté en parallèle du segment LTS et/ou du segment HTS.

5. Commutateur de courant persistant selon l'une quelconque des revendications précédentes, incluant un commutateur thermique (51) entre le segment HTS et un port de liaison thermique (52).

6. Commutateur de courant persistant selon l'une quelconque des revendications précédentes, dans lequel le segment LTS inclut plusieurs sous-segments LTS et le segment HTS inclut un ou plusieurs sous-segments HTS et les sous-segments LTS et les sous-segments HTS des plusieurs sous-segments HTS sont alternativement montés en série.

7. Aimant supraconducteur comprenant un ensemble d'enroulements magnétiques et un commutateur de courant persistant selon l'une quelconque des revendications 1 à 6.

8. Aimant supraconducteur selon la revendication 7 lorsqu'elle dépend de la revendication 5, comprenant un système cryogénique couplé à l'ensemble d'enroulements magnétiques, dans lequel le port de liaison thermique est thermiquement couplé à un tampon thermique (53) du système cryogénique.

9. Procédé de montée en puissance d'un aimant supraconducteur selon la revendication 7 lorsqu'elle dépend de la revendication 4, comprenant la commande du commutateur commandable du conducteur shunt (31, 41) dans son état ouvert alors que le segment HTS est dans son état conducteur normal.

10. Procédé de montée en puissance d'un aimant supraconducteur selon la revendication 8, comprenant la commande du commutateur thermique dans son état fermé pendant la montée en puissance.
